# EUROPEAN PATENT APPLICATION

(11) **EP 1 564 589 A1**
(43) Date of publication of application: **17.08.2005**
(21) Application number: 05002944.6
(22) Date of filing: 11.02.2005
(51) Int. Cl.: G03F 7/029, G03F 7/031

(54) **Photosensitive lithographic printing plate precursor**

(30) Priority: 13.02.2004 JP 2004036442
(71) Applicant: Fuji Photo Film Co., Ltd., Kanagawa (JP)
(72) Inventor: Sakata, Kaku, Yoshida-cho, Haibara-gun, Shizuoka (JP)
(74) Representative: HOFFMANN - EITLE

(57) **Abstract**

A photosensitive lithographic printing plate precursor comprising a support and at least one photopolymerizable layer for imaging by scanning with a laser beam, and showing a difference of 5 µm or smaller between Wa (µm) and Wb (µm) when imagewi se exposed wi th a laser beam and developed in a developing tank containing an aqueous alkali developer in an automatic developing machine, wherein Wa is a width of a line formed along a fast scanning direction and developed using a developing brush set in the developing tank in contact with a surface of the exposed lithographic printing plate precursor, and Wb is a width of a line formed along a fast scanning direction and developed without the developing brush.

## Description

### FIELD OF THE INVENTION

This invention relates to a photosensitive lithographic printing plate precursor and more particularly to a photosensitive lithographic printing plate precursor suited to imaging with laser light and useful for high-precision (corresponding to 200 lpi or more) AM screening or FM screening.

### BACKGROUND OF THE INVENTION

A lithographic printing plate precursor has a water-wettable support and a photosensitive resin layer provided on the support. For making a lithographic printing plate, the lithographic printing plate precursor is usually subjected to mask exposure through a lithographic film, and the non-image area is dissolved and removed with a developer to obtain a desired printing plate.

The recent digitization technology has boosted development of computer-to-plate (CTP) techniques, by which a photosensitive lithographic printing plate is scanned with highly directional light, such as a laser beam, in accordance with digitized image information to achieve imagewise exposure without using a lithographic film. Photosensitive lithographic printing plate precursors fit for the CTP technology have also been developed.

A photosensitive lithographic printing plate precursor having a photopolymerizable layer is among such printing plate precursors fit for laser direct imaging. A photopolymerizable layer can be designed more easily to have high photosensitivity than conventional photosensitive layers by proper selection of a polymerization initiator or a polymerization initiator system (hereinafter simply referred to as an initiator or an initiator system).

Since the photosensitive lithographic printing plate precursor for laser direct imaging is exposed to a laser beam, the sharpness of edges of an image depends on a laser energy distribution profile, and there are formed regions suffering from insufficient polymerization on account of exposure shortage. As a result, the sharpness of the edge of an image is impaired, resulting in a reduction of resolution. The edge of an image suffering from insufficient polymerization undergoes insufficient development in the development processing depending on the alkali concentration of the developer or the condition of a developing brush used in the processing. It follows that the resulting printing plate shows large dot area variation. Besides, the support used in the photosensitive lithographic printing plate precursors has its surface textured by electrolysis, brushing or a like surface graining process so as secure water wettability. The surface roughness of the support causes scatter of reflected light in laser imaging, which further impairs image quality and sharpness , resulting in great reduction in reproducibility of shadows.

With increasing demands for high-precision AM screening and FM screening systems in the field of CTP, resolution of lithographic printing plate precursors has now come to be of importance.

FM (frequency modulated) screening is a digital screening process that randomly places fine dots of about 20 µm irrespective of a screen angle and ruling to represent density gradation by dot density per unit area. FM screening has the following advantages. There is neither moire nor rosette structure. The image does not exhibit tone-scale jump in midtones. Because the dots are small, overlapping of dots is reduced so that reproduced colors look bright.

On the other hand, AM (amplitude-modified) - screening regularly arranges dots at a fixed angle to represent density gradation by the dot size per unit area. The AM screen ruling adopted in Japan is 175 lpi. AM screening using a ruling of 200 lpi or more is generally called high-precision AM screening.

Outputs of high-precision AM screen printing are characterized by reduced Moire, reduced rosette pattern, improved image texture, improved image realism, increased reproduction of details, and the like.

Light-sensitive materials that reduce reproducibility of shadows, such as those used in lithographic printing plate precursors having the above-mentioned photopolymerizable layer, are incapable of reproducing extremely small dots and therefore difficult to apply to photosensitive lithographic printing plate precursors for FM screening or high-precision AM screening.

JP-A-2003-43703 discloses a photosensitive lithographic printing plate precursor comprising a support, an intermediate layer containing a polymer having a structural unit with a sulfonic acid group in the side chain, and a photopolymerizable layer, which is still insufficient for application to high-precision AM screen printing or FM screen printing. In particular, the precursor suffers from noticeable tint unevenness in FM screening and is difficult to apply to FM screening.

### SUMMARY OF THE INVENTION

An object of the present invention is to provide a photosensitive lithographic printing plate precursor fit to laserimaging, high-precision AM screeningata ruling of 200 lpi or more or FM screening, and capable of providing a printing plate with satisfactory tint uniformity in midtones in FM screening.

As a result of extensive investigations, the present inventors have found that the object of the invention is accomplished by a photosensitive lithographic printing plate precursor having a support and at least one photopolymerizable layer for imaging by scanning with a laser beam. When the printing plate precursor is imagewise exposed with a laser beam and developed in a developing tank containing an aqueous alkali developer in an automatic developing machine, the difference between width Wa (µm) of a line along the fast scanning direction that is developed using a developing brush set in the developing tank in contact with the surface of the exposed lithographic printing plate precursor and with Wb (µm) of a line along the fast scanning direction that is developed in the same manner except for using no developing brush is 5 µm or smaller.

The present invention embraces preferred embodiments of the photosensitive lithographic printing plate precursor, in which:
1) The photopolymerizable layer contains (A) a sensitizing dye having an absorption maximum in a wavelength region of from 360 nm to 450 nm, (B) a polymerization initiator, and (C) an addition polymerizable compound having an ethylenically unsaturated double bond.
2) The photopolymerizable layer further contains (D) a binder polymer in addition to components (A) to (C) described above at a (C) to (D) weight ratio of 1.5 or less.

The present invention provides a photosensitive lithographic printing plate precursor fit to laser imaging, high-precision AM screening at a ruling of 200 lpi or more or FM screening. A lithographic printing plate obtained by using the precursor of the invention exhibits satisfactory tint uniformity in midtones in FM screen printing.

### DETAILED DESCRIPTION OF THE INVENTION

The photosensitive lithographic printing plate precursor of the present invention is characterized in that the fine line width difference, Wb - Wa, arising from whether development is carried out with or without a developing brush is not greater than 5 µm.

The "line width (Wa or Wb)" as referred to here is decided by setting conditions of a platesetter, including laser beam diameter, resolution, and output. Line width measurement is performed as follows. In measuring a line width, it is desirable to scan a printing plate precursor with a laser beam having a half value width of about 10 µm corresponding to 2000 to 3000 dpi, which are resolutions common to platesetters currently on the market, and to use one-pixel lines or two-pixel lines arrayed at a pitch corresponding to the resolution.

The output of a laser varies depending on a light source and is varied depending on the photopolymerizable material. The exposure energy of a laser is desirably such that, when the photosensitive lithographic printing plate precursor of the invention is developed in a developing machine equipped with a developing brush, at least 90%, more desirably 95% or more, of a solid image density remains.

The printing plate precursor thus exposed is developed in a given automatic developing machine having a developing bath in which a developing brush is attached. The developed one-pixel or two-pixel lines on the resulting printing plate are photographed at a certain magnification with an optical microscope, a microscope, an electron microscope, etc. The line width reproduced on the micrograph is measured.

The line width difference, Wb - Wa, is preferably 4.5 µm or smaller.

Any developing brush that is used in known automatic developing machines for PS plates can be used in the invention with no limitations in material and shape. Developing brushes of the shapes or produced by the methods described in JP-A-2001-5194 and JP-A-2001-133990 are preferred.

The support that can be used in the photosensitive lithographic printing plate precursor of the present invention is not particularly limited as long as its surface is water-wettable. Those materials that are dimensionally stable are preferred, such as paper, paper laminated with a resin (e.g., polyethylene, polypropylene or polystyrene), a sheet of a metal (e.g. , aluminum, zinc or copper) or its alloy (e.g., with silicon, copper, manganese, magnesium, chromium, zinc, lead, bismuth or nickel), a film of a resin (e.g., cellulose diacetate, cellulose triacetate, cellulose propionate, cellulose butyrate, cellulose butyrate acetate, cellulose nitrate, polyethylene terephthalate, polyethylene, polystyrene, polypropylene, polycarbonate or polyvinyl acetal), and paper or a resin film laminated or deposited with the above-recited metal or alloy. Of these supports preferred is an aluminum sheet in view of its outstanding dimensional stability and low cost. Acomposite sheet composed of a polyethylene terephthalate film and an aluminum sheet as disclosed in JP-B-48-18327 is also preferred. The thickness of the support is usually about 0.05 to 1 mm.

A support having a metal, especially aluminum, on its surface is preferably subjected to a surface treatment, such as graining, immersion in an aqueous solution of sodium silicate, potassium fluorozirconate, a phosphate, etc., or anodizing.

Graining includes mechanical graining, chemical graining, and electrolytic graining as taught in JP-A-56-28893; electrochemical graining in an electrolytic solution containing hydrochloric acid or nitric acid; and other mechanical graining techniques such as wire brush graining (the aluminum surface is scratched with metal wire), ball graining with abrasive balls and a polishing agent, and brush graining with a nylon brush and a polishing agent. These graining techniques can be used either individually or as a combination thereof.

Electrochemical graining in a hydrochloric acid electrolytic solution or a nitric acid electrolytic solution is preferred to prepare an aluminum support for use in the invention. A suitable current density is 100 to 400 C/dm². In more detail, electrochemical graining is preferably carried out in, for example, an electrolytic solution having a hydrochloric acid or nitric acid concentration of 0.1% to 50% by weigh at a temperature of 20° to 100°C for 1 second to 30 minutes at a current density of 100 to 400 C/dm².

The grained aluminum plate is then chemically etched with an acid or alkali etchant. Alkali etching is preferred to acid etching because acid etching needs time to destroy the microstructure. The alkalis that are suitably used in the invention include sodium hydroxide, sodium carbonate, sodium aluminate, sodium metasilicate, sodium phosphate, potassium hydroxide, and lithium hydroxide. The etchant preferably has an alkali concentration of 1% to. 50% by weight and a temperature of 20° to 100°C. These etching conditions are preferably selected so that 5 to 20 g/m³ of aluminum may be etched out.

After alkali etching, the aluminum sheet is desmutted with an acid, such as nitric acid, sulfuric acid, phosphoric acid, chromic acid, hydrofluoric acid or fluoroboric acid. Desmutting after electrochemical graining is preferably effected with 15% to 65 wt% sulfuric acid at 50° to 90°C as taught in JP-53-12739 or by alkali etching as proposed in JP-B-4 8-28123.

The aluminum support that is preferably used in the invention has a mean surface roughness Ra of 0.3 to 0.7 µm.

The resulting aluminum sheet is preferably subjected to anodizing in a conventional manner to form an anodized film on the aluminum surface. Anodizing is carried out by applying a direct current or an alternating current to the aluminum sheet in an aqueous or nonaqueous solution of sulfuric acid, phosphoric acid, chromic acid, oxalic acid, sulfamic acid, benzenesulfonic acid, etc. or a mixture of two or more of these acids.

Anodizing conditions vary depending on the kind of the electrolyte used. Generally speaking, the electrolyte concentration is 1% to 80% by weight, the liquid temperature is 5° to 70°C, the current density is 0.5 to 60 A/dm², the voltage is 1 to 100 V, and the electrolysis time is 10 to 100 seconds. The anodizing method disclosed in British Patent 1,412,768, in which a high current density is applied in a sulfuric acid electrolytic solution, and the method disclosed in U.S. Patent 3,511,661 using phosphoric acid electrolytic solution are particularly preferred.

A suitable thickness of the anodized film is 1 to 10 g/m², preferably 1.5 to 7 g/m², still preferably 2 to 5 g/m².

The grained and anodized support may be subjected to sealing. Sealing of an anodizedfilmis carried out by immersion in hot water that may contain an inorganic or organic salt or steaming. The support may further be subjected to a surface treatment other than silicating with an alkali metal silicate, such as immersion in an aqueous solution of potassium fluorozirconate or a phosphate.

The support (in the case of an aluminum support, an appropriately surface treated aluminum support as described above is preferred) is coated with a photopolymerizable composition to forma photopolymerizable layer, and a protective layer is applied thereon to provide a photosensitive lithographic printing plate precursor of the invention. If desired, an organic or inorganic primer coat may be provided on the support before application of the photopolymerizable layer, or the support may be subjected to sol-gel treatment for covalently bonding a functional group capable of radical-induced addition reaction as proposed in JP-A-7-159983.

Materials of an organic primer coat include water soluble resins, such as polyvinylphosphonic acid, a homo- or copolymer having a sulfonic acid group in the side chain thereof, and polyacrylic acid, water solublemetal salts (e.g., zincborate), yellow dyes, and amine salts. Specific examples of such organic materials include carboxymethyl cellulose, dextrin, gum arabic; organic phosphonic acids such as amino-containing phosphonic acids (e.g., 2-aminoethylphosphonic acid), substituted or unsubstituted phenylphosphonic acid, naphthylphosphonic acid, alkylphosphonic acids, glycerophosphonic acid, methylenediphosphonic acid, and ethylenediphosphonic acid; organic phosphoric acids, such as substituted or unsubstituted phenylphosphoric acid, naphthylphosphoric acid, alkylphosphoric- acids, and glycerophosphoric acid; organic phosphinic acids, such as substituted or unsubstituted phenylphosphinic acid, naphthylphosphinic acid, alkylphosphinic acids, and glycerophosphinic acid; amino acids, such as glycine and β-alanine; and hydroxyl-containing amine hydrochlorides, such as triethanolamine hydrochloride. These organic compounds can be usedeither individually or as a mixture of two or more thereof.

The organic primer coat can be provided by applying a solution of the above-described organic compound in water, an organic solvent (e.g. , methanol, ethanol or methyl ethyl ketone) or a mixture thereof to the support, followed by drying. Alternatively, the support is dipped in the solution to make the compound be adsorbed, followed by washing with water, etc. and drying. The solution to be used in the former method has a concentration of 0.005% to 10% by weight. The solution can be applied by any coating technique, such as bar coating, spin coating, spraying, or curtain coating. The solution to be used in the latter method has a concentration of 0.01% to 20% by weight, preferably 0.05% to 5% by weight. The latter method is carried out by dipping the support in the solution at 20° to 90°C, preferably 25° to 50°C, for 0.1 second to 20 minutes, preferably 2 seconds to 1 minute. The solution to be applied may be adjusted to a pH of 1 to 12 with a basic substance, e. g. , ammonia, triethylamine or potassium hydroxide, or an acidic substance, e.g., hydrochloric acid or phosphoric acid. The solution may contain a yellow dye for improving tone reproducibility of the lithographic printing plate precursor.

The coating weight of the primer coat is suitably 2 to 200 mg/m², preferably 5 to 100 mg/m², on a solid basis for assuring a sufficient press life.

Materials of an inorganic primer coat include inorganic salts, such as cobalt acetate, nickel acetate, and potassium fluorotitanate. The inorganic primer coat can be applied in the same manner as for the organic primer coat.

The photosensitive layer of the photosensitive lithographic printing plate precursor of the invention has spectral sensitivity at least in a wavelength region of from 360 nm to 450 nm. The photosensitive layer preferably contains (A) a sensitizing dye having an absorption maximum in a wavelength region of from 360 nm to 450 nm, (B) a polymerization initiator, and (C) an addition polymerizable compound having an ethylenically unsaturated double bond.

### [I] Component (A): sensitizing dye

The sensitizing dye that can be used in the photosensitive layer has an absorption maximum in a wavelength region of 360 to 450 nm. Such sensitizing dyes include merocyanine dyes represented by formula (II), benzopyrans and coumarins represented by formula (III), aromatic ketones represented by formula (IV), and anthracenes represented by formula (V). 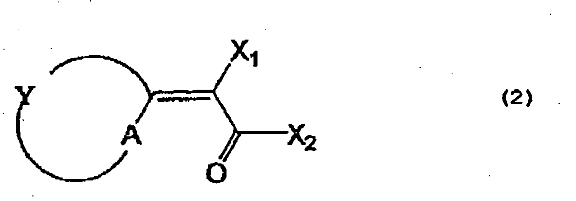 wherein A represents a sulfur atom or NR₆; R₆ represents a monovalent nonmetallicatomic group; Y represents a nonmetallic atomic group necessary to form a basic nucleus of the dye together with the adjacent A and carbon atom; and X₁ and X₂ each represent a monovalent nonmetallic atomic group, or X₁ and X₂ are taken together to form an acidic nucleus of the dye. 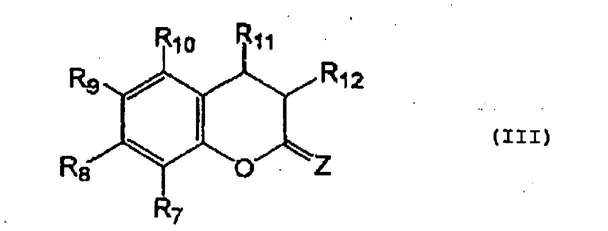 wherein =Z represents a carbonyl group, a thiocarbonyl group, an imino group or an alkylidene group represented by partial structure: 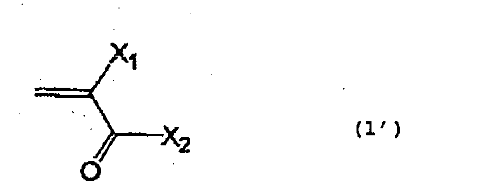 X₁ and X₂ are as defined above; and R₇, R₈, R₉ , R₁₀, R₁₁, and R₁₂ each represent a monovalent nonmetallic atomic group. 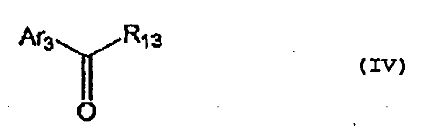 wherein Ar₃ represents a substituted or unsubstituted aromatic group or a substituted or unsubstituted heterocyclic aromatic group; and R₁₃ represents a monovalent nonmetallic atomic group, preferably an aromatic group or a heterocyclic aromatic group; or Ar₃ and R₁₃ may be taken together to form a ring. 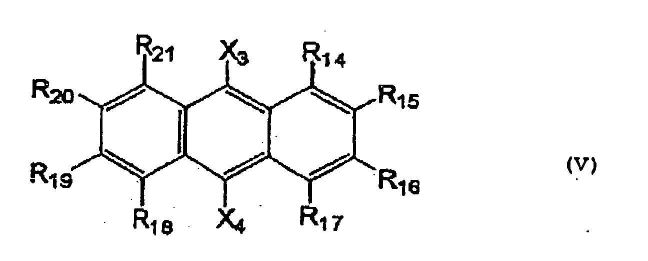 wherein X₃, X₄, R₁₄, R₁₅, R₁₆, R₁₇, R₁₈, R₁₉, R₂₀, and R₂₁ each represent a monovalent nonmetallic atomic group; X₃ and X₄ each preferably represent an electron donating group having a negative Hammet' s substituent constant.

Preferred examples of the monovalent nonmetallic atomic groups represented by X₁ to X₄ and R₆ to R₂₁ in formulae (II) to (V) include an alkyl group (e.g., methyl., ethyl, propyl, butyl, pentyl, hexyl, heptyl, octyl, nonyl, decyl, undecyl, dodecyl, tridecyl, hexadecyl, octadecyl, eicosyl, isopropyl, isobutyl, sec-butyl, t-butyl, isopentyl, neopentyl, 1-methylbutyl, isohexyl, 2-ethylhexyl, 2-methylhexyl, cyclohexyl, cyclopentyl, 2-norbornyl, chloromethyl, bromomethyl, 2-chloroethyl, trifluoromethyl, methoxymethyl, methoxyethoxyethyl, allyloxymethyl, phenoxymethyl, methylthiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonoxypropyl, phosphonatoxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl or 2-methylpropenylmethyl), an aryl group (e.g., phenyl, biphenyl, naphthyl, tolyl, xylyl, mesityl, cumenyl, chlorophenyl, bromophenyl, chloromethylphenyl, hydroxyphenyl, methoxyphenyl, ethoxyphenyl, phenoxyphenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxyphenylcarbonyl, phenoxycarbonylphenyl, N-phenylcarbamoylphenyl, cyanophenyl, sulfophenyl, sulfonatophenyl, phosphonophenyl or phosphonatophenyl), a heteroaryl group (e.g., thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolidine, isoquinoline, phthalazine, naphthyridine, quinazoline, cinnoline, pteridine, carbazole, carboline, phenanthrene, acridine, perimidine, phenanthroline, phenarsazine, phenoxazine or furazan), an alkenyl group (e.g., vinyl, 1-propenyl, 1-butenyl, cinnamyl or 2-chloro-1-ethenyl), an alkynyl group (e.g., ethynyl, 1-propynyl, 2-propynyl, 1-butynyl, 2-butynyl, 3-butynyl or trimethylsilylethynyl), a halogen atom (e.g., fluorine, bromine, chlorine or iodine), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N, N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N' -alkylureido group, an N',N'-dialkylureido group, an N'-arylureido group, an N' ,N' -diarylureido group, an N' -alkyl-N' -arylureido group, an N-alkylureido group, an N-arylureido group, an N' -alkyl-N-alkylureido group, an N' -alkyl-N-arylureido group, an N',N'-dialkyl-N-alkylureido group, N',N'-dialkyl-N-arylureido group, an N'-aryl-N-alkylureido group, N'-aryl-N-arylureido group, an N' ,N' -diaryl-N-alkylureido group, N' ,N' -diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamayl group, anN-alkyl-N-arylcarbamoyl group, an alkylsulfinyl group, an arylsulfinyl group, an alkylsulfonyl group, an arylsulfonyl group, a sulfo group (-SO₃H) and a conjugated base group thereof (a sulfonate group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsufamoyl group, an N-arylsulfamoyl group, an N,N-diarylsulfamoyl group, an N-alkyl-N-arylsulfamoyl group, a phosphono group (-PO₃H₂) and its conjugated base group (a phosphonate group), a dialkylphosphono group (-PO₃H(alkyl)₂), a diarylphosphono group (-PO₃(aryl)₂), an alkylarylphosphono group (-PO₃ (alkyl) (aryl)), a monoal kylphosphono group (-PO₃H(alkyl)) and its conjugated base group (an alkylphosphonate group), a monoarylphosphono group (-PO₃H(aryl)) and its conjugated base group (an arylphosphonate group), a phosphonoxy group (-OPO₃H₂) and its conjugated base group (a phosphonatoxy group), a dialkylphosphonoxy group (-OPO₃(alkyl)₂), a diarylphosphonoxy group (-OPO₃(aryl)₂)), an alkylarylphosphonoxy group (-OPO₃(alkyl) (aryl)), a monoalkylphosphonoxy group (-OPO₃H(alkyl)) and its conjugated base group (an alkylphosphonatoxy group), a monoarylphosphonoxy group (-OPO₃H(aryl)) and its conjugatedbase group (an arylphosphonatoxy group), a cyano group, and a nitro group. Preferred of them are a hydrogen atom, an alkyl group, an aryl group, a halogen atom, an alkoxy group, and an acyl group.

The basic nucleus of the dye represented by formula (II), i. e. , the ring completed by Y together with the adjacent carbon atom and A, includes 5-, 6- or 7-membered, nitrogen- or sulfur-containing heterocyclic rings, preferably 5- or 6-membered heterocyclic rings.

Any nitrogen-containing heterocyclic rings known to constitute a basic nucleus in merocyanine dyes can be used in formula (II), including those described in L.G. Brooker, et al., *J*. Am. *Chem. Soc.,* vol. 73 (1951), pp. 5326-5358 and the reference literature cited therein. Specific examples thereof include thiazoles (e.g., thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), and 4-(2-thienyl)thiazole), benzothiazoles (e.g., benzothiazole, 4-chlorobenzathiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole, and 5-ethoxycarbonylbenzothiazole), naphthothiazoles (e.g., naphtho[1,2]-thiazole, naphtho[2,1]thiazole, 5-methoxynaphtho[2,1]thiazole, 5-ethoxynaphtho[2,1]thiazole, 8-methoxynaphtho[1,2]-thiazole, and 7-methoxynaphtho[1,2]thiazole), thianaphtheno-7',6',4,5-thiazoles (e.g., 4'-methoxythianaphtheno-7',6',4,5--thiazole), oxazoles (e.g., 4-methyloxazole, 5-methyloxazole, 4-phenyloxazole, 4,5-diphenyloxazole, 4-ethyloxazole, 4,5-dimethyloxazole, and 5-phenyloxazole), benzoxazoles (e.g., benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, and 6-hydroxybenzoxazole), naphthoxazoles (e.g., naphth[1,2]oxazole and naphth[2,1]oxazole), selenazoles (e.g., 4-methylselenazole and 4-phenylselenazole), benzoselenazoles (e.g., benzoselenazole, 5-chlorobenzoselenazole, 5-methoxybenzoselenazole, 5-hydroxybenzoselenazole, and tetrahydrobenzoselenazole), naphthoselenazoles (e.g., naphtho[1,2]selenazole and naphtho[2,1]selenazole), thiazolines (e.g., thiazoline and 4-methylthiazoline), 2-quinolines (e.g., quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, and 8-hydroxyquinoline), 4-quinolines (e.g., quinoline, 6-methoxyquinoline, 7-methylquinoline, and 8-methylquinoline), 1-isoquinolines (e.g., isoquinoline and 3,4-dihydroisoquinoline), 3-isoquinolines (e.g., isoquinoline), benzimidazoles (e.g., 1,3-diethylbenzimidazole and 1-ethyl-3-phenylbenzimidazole), 3,3-dialkylindolenines (e.g., 3,3-dimethylindolenine, 3,3,5-trimethylindolenine, and 3,3,7-trimethylindolenine), 2-pyridines (e.g., pyridine and 5-methylpyridine), and 4-pyridines (e.g., pyridine).

The sulfur-containing heterocyclic ring includes the dithiol partial structures in the dyes described in JP-A-3-296759. Specific examples thereof are benzodithiols (e.g., benzodithiol, 5-t-butylbenzodithiol, and 5-methylbenzodithiol), naphthodithiols (e.g., naphtho-[1,2]dithiol and naphtho[2,1]dithiol) and dithiols (e.g., 4,5-dimethyldithiol, 4-phenyldithiol, 9 -methoxycarbonyldithio1,4,5-dimethoxycarbonylbenzodithiol, 9,5-ditrifluoromethyldithiol, 4,5-dicyanodithiol, 4-methoxycarbonyl-methyldithiol, and 4-carboxymethyldithiol).

The above-recited heterocyclic rings are named as heterocyclic skeletons for the sake of convenience but are actually introduced into the sensitizing dyes in a form with their degree of unsaturation reduced by one like an alkylidene form. For example, a benzothiazole ring is introduced in the form, e.g., of a 3-substituted-2(3H)-benzothiazolylidene group.

Of the sensitizing dyes having an absorption maximum in a wavelength region of 360 to 450 nm, those represented by formula (I) shown below are preferred for their high sensitivity. 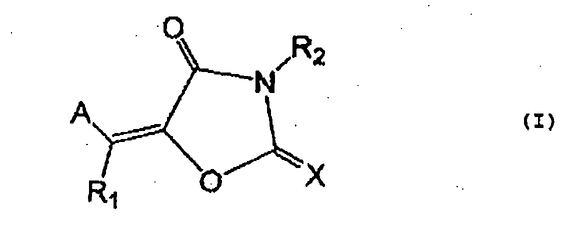 wherein A represents a substituted or unsubstituted aromatic group or a substituted or unsubstituted heterocyclic group; X represents an oxygen atom, a sulfur atom or NR₃; R₁, R₂, and R₃ each represent a hydrogen atom or a monovalent nonmetallic atomic group; A and R₁ may be connected together, and R₂ and R₃ may be connected together, each to form an aliphatic or aromatic ring.

In formula (I), R₁, R₂, and R₃ each preferably represent a substituted or unsubstituted alkyl group, a substituted or unsubstituted heteroaryl group, a substituted or unsubstituted alkenyl group, a substituted or unsubstituted aryl group, a substituted or unsubstituted aromatic heterocyclic group, a substituted or unsubstituted alkoxy group, a substituted or unsubstituted alkylthio group, a hydroxyl group or a halogen atom.

The substituents represented by R₁, R₂ and R₃ will be described in greater detail. The alkyl group preferably includes straight chain, branched or cyclic alkyl groups having from 1 to 20 carbon atoms. Specific examples are methyl, ethyl, propyl, butyl, pentyl, hexyl, heptyl, octyl, nonyl, decyl, undecyl, dodecyl, tridecyl, hexadecyl, octadecyl , eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl, and 2-norbornyl. Straight chain alkyl groups having from 1 to 12 carbon atoms, branched alkyl groups having from 3 to 12 carbon atoms, and cyclic alkyl groups having from 5 to 10 carbon atoms are still preferred.

These alkyl groups may be substituted with a monovalent non-metallic atomic group other than hydrogen. Preferred substituents of the substituted alkyl groups include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N' -alkylureido group, an N' ,N' -dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido groups, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugated base group thereof (hereinafter, a sulfonate group) an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-aryl sulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugated base group thereof (hereinafter, a phosphonate group), a dialkylphosphono group (-PO₃(alkyl)₂), a diarylphosphono group (-PO₃(aryl)₂), an alkylarylphosphono group (-PO₃(alkyl) (aryl)), a monoalkylphosphono group (-PO₃H(alkyl)) and a conjugated base group thereof (hereinafter, alkylphosphonate group), a monoarylphosphono group (-PO₃H(aryl)) and a conjugated base group thereof (hereinafter, arylphosphonate group), a phosphonoxy group (-OPO₃H₂) and a conjugated base group thereof (hereinafter, phosphonatoxy group), a dialkylphosphonoxy group (-OPO₃(alkyl)₂), a diarylphosphonoxy group (-OPO₃(aryl)₂), an alkylarylphosphonoxy group (-OPO₃(alkyl) (aryl)), a monoalkylphosphonoxy group (-OPO₃H(alkyl)) and a conjugated base group thereof (hereinafter, alkylphosphonatoxy group), a monoarylphosphonoxy group (-OPO₃H(aryl)) and a conjugated base group thereof (hereinafter, arylphosphonatoxy group), a cyano group, a nitro group, an aryl group, a heteroaryl group, an alkenyl group, and an alkynyl group.

The alkyl moieties in these substituents of the substituted alkyl groups include the unsubstituted alkyl groups recited above as R₁, R₂, and R₃. The aryl moieties in the substituents of the substituted alkyl groups include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxylphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a cyanophenyl group, a sulfophenyl group, a sulfonatophenyl group, a phosphonophenyl group, and a phosphonatophenyl group.

The heteroaryl group as R₁, R₂, and R₃ is preferably a monocyclic or polycyclic aromatic ring containing at least one of nitrogen, oxygen and sulfur atoms. Examples of particularly preferred heteroaryl groups are thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolidine, isoquinoline, phthalazine, naphthyridine, quinazoline, cinnoline, pteridine, carbazole, carboline, phenanthrene, acridine, perimidine, phenanthroline, phenarsazine, phenoxazine, and furazan. These rings may have a benzo group fused or may have a substituent.

Preferred examples of the alkenyl, group as R₁, R₂, and R₃ includes a vinyl group, a 1-propenyl group, a 1-butenyl group, a cinnamyl group, and a 2-chloro-1-ethenyl group. Examples of the alkynyl group as R₁, R₂, and R₃ include an ethynyl group, a 1-propynyl group, a 1-butynyl group, and a trimethylsilylethynyl group. Examples of G₁ in the acyl group (G₁CO-) include a hydrogen atom and the above-recited alkyl groups and aryl groups. Still preferred of these substituents are a halogen atom (e.g. , fluorine, bromine, chlorine or iodine), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonate group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonate group, a dialkylphosphono group, a diarylphosphono group, a monoalkylphosphono group, an alkylphosphonate group, a monoarylphosphono group, an arylphosphonate group, a phosphonoxy group, a phosphonatoxy group, an aryl group, and an alkenyl group.

The alkylene group in the substituted alkylene group includes a divalent organic residue derived from the above-recited alkyl group having from 1 to 20 carbon atoms by removing one of the hydrogen atoms. Straight chain alkylene groups having from 1 to 12 carbon atoms, branched alkylene groups having from 3 to 12 carbon atoms, and cyclic alkylene groups having from 5 to 10 carbon atoms are still preferred.

Specific examples of preferred substituted alkyl groups as R₁, R₂, and R₃ are a chloromethyl group, a bromomethyl group, a2 -chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group; a 2-methylpropenylmethyl group, a 2-propynyl group, a 2-butynyl group, and a 3-butynyl group.

The aryls group as R₁, R₂, and R₃ preferably include a phenyl group, condensed polycyclic aryl groups composed of two or three benzene rings, and condensed polycyclic aryl groups composed of a benzene ring and a 5-membered unsaturated ring. Specific examples include a phenyl group, a naphthyl group, an anthryl group, a phenanthryl group, an indenyl group, an acenaphthenyl group, and a fluorenyl group. A phenyl group and a naphthyl group are still preferred.

The substituted aryl groups as R₁, R₂, and R₃ include those having a monovalent nonmetallic atomic group (other than a hydrogen atom) as a substituent on the ring-forming carbon atom(s) of the foregoing aryl groups. Examples of preferred substituents of the substituted aryl groups include the foregoing alkyl groups and substituted alkyl groups, and those enumerated above as the substituent in the foregoing substituted alkyl groups. Specific examples of preferred substituted aryl groups are a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethyl ami nophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group,an N-methylbenzoylaminophenyl group, a carboxyphenyl group, a methoxycarbonylphenyl group, an allyloxycarbonylphenyl group, a chlorophenaxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N- (sulfophenyl) carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group, and a 3-butynylphenyl group.

The substituted or unsubstituted aromatic group and substituted or unsubstituted heterocyclic group as represented by A in formula (I) include those recited with respect to R₁, R₂, and R₃.

The compounds represented by formula (I) are obtained by condensation between the above-described acidic nucleus or an active methylene -containing acidic nucleus and a substituted or unsubstituted aromatic ring or heterocyclic ring. For the synthesis, reference can be made to JP-B-59-28329.

Specific examples of the compounds represented by formula (I) which are particularly preferred in the present invention are shown below. Each of the compounds shown, (D1) through (D38), is not limited to either of the isomers attributed to the double bond connecting the acid nucleus and the basic nucleus.

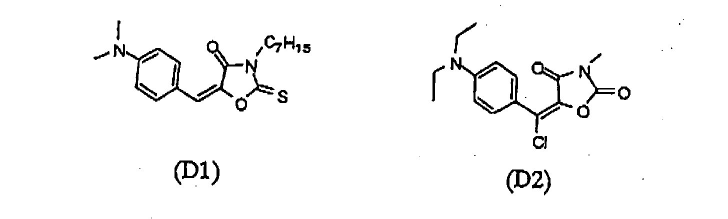

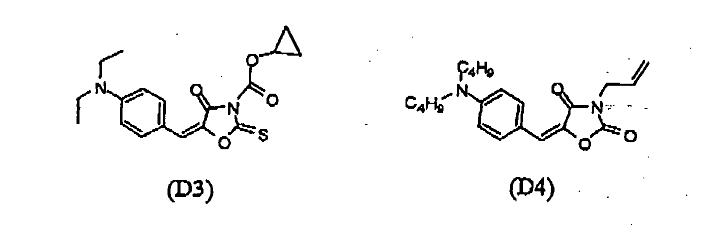

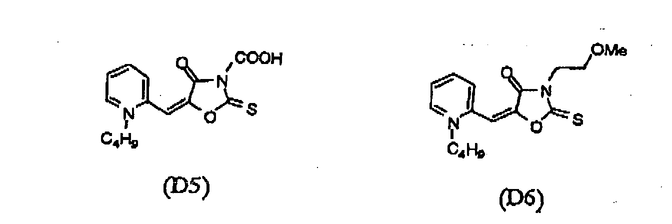

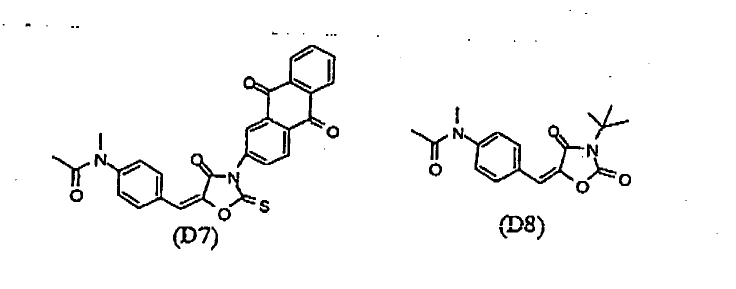

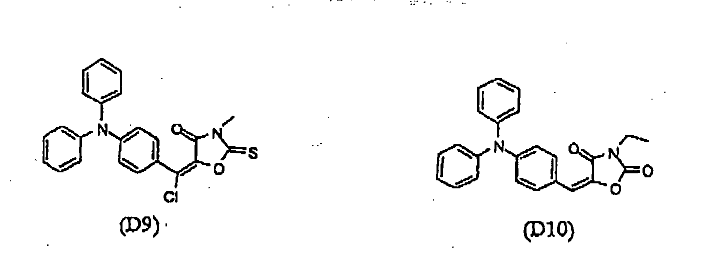

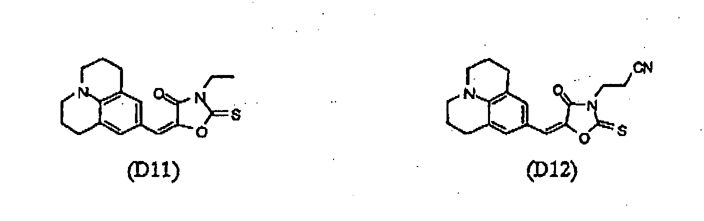

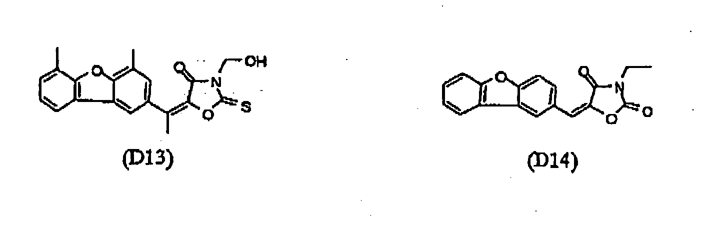

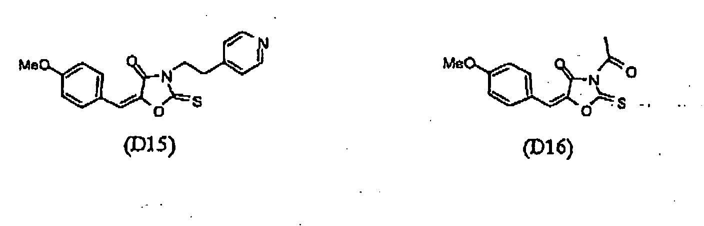

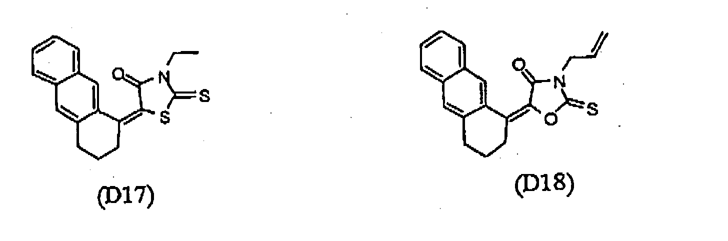

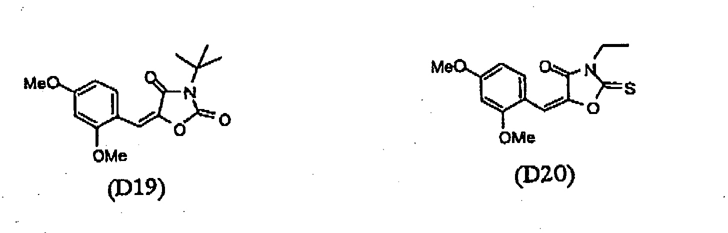

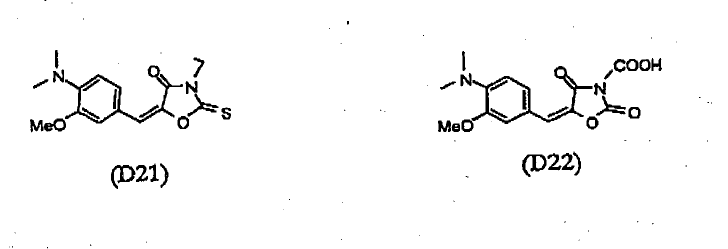

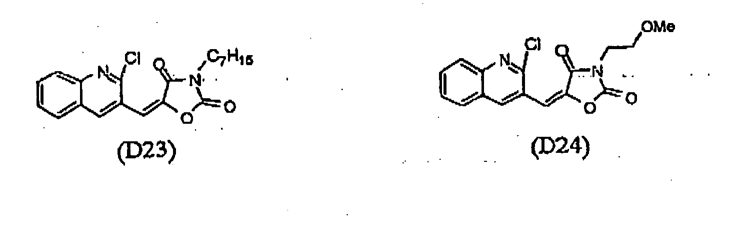

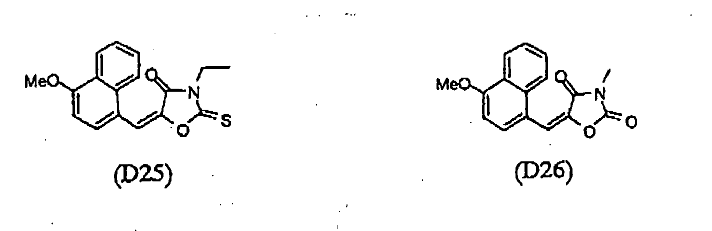

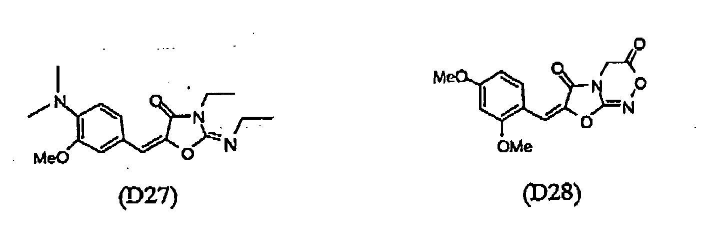

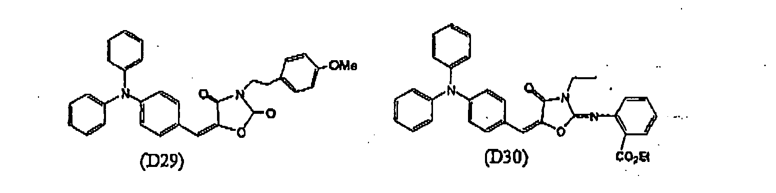

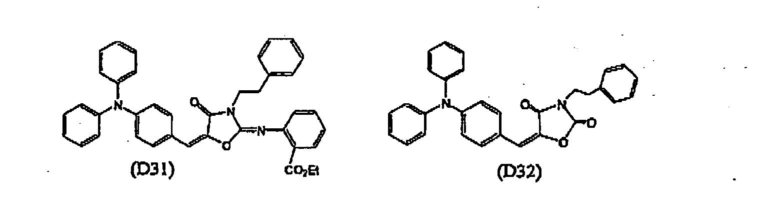

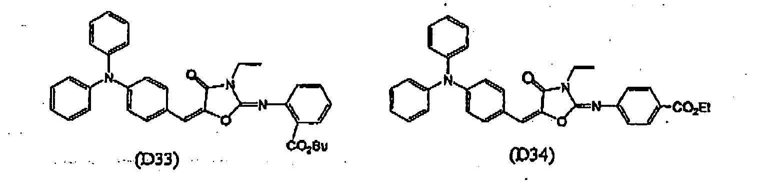

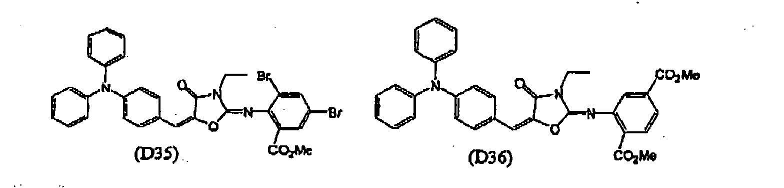

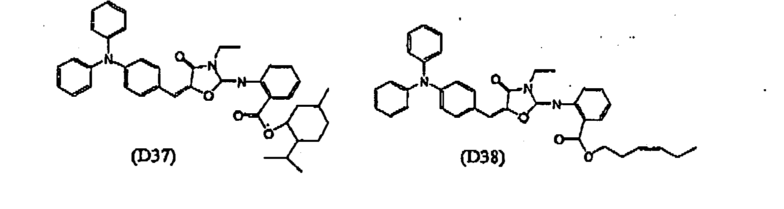

The sensitizing dye as component (A) is preferably used in an amount of 1.0% to 10.0% by weight, still preferably 1.0% to 5 .0% by weight, based on the total weight of the photosensitive layer.

### [II] Component (B): Polymerization initiator

The polymerization initiator that can be used in the photosensitive layer can be at least one initiators appropriately selected from those known from patents and other literature. The term "polymerization initiator (or simply initiator)" as used hereunder is intended to include a polymerization initiator system composed of two or more initiators.

In using a light source emitting light around 400 nm, for instance, benzil, benzoyl ether, Michler's ketone, anthraquinone, thioxanthone, acridine, phenazine, benzophenone, and so on are widely used as an initiator.

In addition, there are various polymerization initiators proposed for use in exposure to visible light of wavelengths longer than 400 nm, such as systems comprising a specific photoreducing dye described in U.S. Patent 2,850,445 (e.g., rose bengal, eosin or erythrosin) or a dye and a photopolymerization initiator. Example of such systems include a composite initiator system comprising a dye and an amine (JP-B-44-20189), a combination system comprising hexaarylbiimidazole, a radical generator, and a dye (JP-B-45-37377), a system comprising hexaarylbiimidazole and a p-dialkylaminobenzylidene ketone (JP-B-47-2528 and JP-A-54-155292), a system comprising a cyclic cis-α-dicarbonyl compound and a dye (JP-A-48-84183), a system comprising a cyclic triazine compound and a merocyanine dye (JP-A-54-151024), a system comprising a 3-ketocoumarin compound and an active agent (JP-A-52-112681 and JP-A-58-15503), a system comprising a biimidazole, a styrene derivative, and a thiol (JP-A-59-140203), a system comprising an organic peroxide and a dye (JP-A-59-1504 , JP-A-59-140203, JP-A-59-189340. JP-A-62-174203, JP-B-62-1641 and U.S. Patent 4,766,055), a system comprising a dye and an active halogen compound (JP-A-63-1718105, JP-A-63-258903, and JP-A-2-63054), a system comprising a dye and a borate compound (JP-A-62-143044, JP-A-62-150242, JP-A-64-13140, JP-A-64-13141, JP-A-64-13142, JP-A-64-13143, JP-A-64-13194, JP-A-64-17048, JP-A-1-229003, JP-A-1-298348, JP-A-1-138240), a system comprising a dye having a rhodanine ring and a radical generator (JP-A-2-179643 and JP-A-2-244050). Titanocene compounds are also cited as preferred polymerization initiators. Titanocene compounds to be used are selected appropriately from known ones described, e.g., in JP-A-59-152396 and JP-A-61-151197.

Example of such titanocene compounds include dicyclopentadienyl titanium dichloride, dicyclopentadienyl bisphenyl titanium, dicyclopentadienyl bis(2,3,4,5, 6-pentafluorophen-1-yl) titanium, dicyclopentadienyl bis(2,3,5,6-tetrafluorophen-1-yl) titanium, dicyclopentadienyl bis(2,4,6-trifluorophen-1-yl) titanium, dicyclopentadienyl bis(2,6-difluorophen-1-yl) titanium, dicyclopentadienyl bis(2,4-diflurorphen-1-yl) titanium, di(methylcyclopentadienyl) bis(2,3,4,5,6-pentafluorophen-1-yl) titanium, di(methylcyclopentadienyl) bis(2,3,5,6-tetrafluorophen-1-yl) titanium, di(methylcyclopentadienyl) bis(2,4-difluorophen-1-yl) titanium, and dicyclopentadienyl bis(2,6-difluoro-3-(pyr-1-yl) phenyl) titanium.

As particularly preferred polymerization initiators, biimidazoles such as hexaarylbiimidazole and titanocene compounds are cited. When biimidazoles are utilized, known chain transfer agents such as mercapto compound are preferably utilized in combination with the biimidazoles in order to improve a sensitibity.

The polymerization initiator as component (B) is preferably used in an amount of 0.5% to 10.0% by weight, still preferably 1.0% to 5.0% by weight, based on the total weight of the photosensitive layer.

### [III] Component (C): Addition polymerizable compound having ethylenically unsaturated double bond

Addition polymerizable compounds used as component (C) preferably have two or more ethylenically unsaturated bonds per molecule. The addition polymerizable compound having at least one ethylenically unsaturated double bond will be simply referred to as an ethylenically unsaturated compound. These compounds occur in chemical forms such as monomers, prepolymers, i.e., dimers, trimers and oligomers, as well as mixtures thereof and copolymers thereof. Examples of the monomeric compounds include esters formed of unsaturated carboxylic acids (e.g., acrylic acid, methacrylic acid, itaconic acid, crotonic acid, isocrotonic acid, and maleic acid) and aliphatic polyhydric alcohols and mixtures thereof, and amides formed of unsaturated carboxylic acids and aliphatic polyamines and mixtures thereof.

The esters between acrylic acid and aliphatic polyhydric alcohols include ethylene glycol diacrylate, triethylene glycol diacrylate, 1, 3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

The esters between methacrylic acid and aliphatic polyhydric alcohols include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis(p-(3-methacryloxy-2-hydroxypropoxy)phenyl)dimethylmeth ane, and bis(p-(methacryloxyethoxy)phenyl)dimethylmethane.

The itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate. The crotonic acid esters include ethylene glycol dicrotonate, tetramethylene glycol dicrotonate, pentaerythritol dicrotonate, and sorbitol tetradicrotonate. The isocrotonic acid esters include ethylene glycol diisocrotonate, pentaerythritol diisocrotonate, and sorbitol tetraisocrotonate. The maleic acid esters include ethylene glycol dimaleate, triethylene glycol dimaleate, pentaerythritol dimaleate, and sorbitol tetramaleate.

The amide monomers between aliphatic polyamines and unsaturated carboxylic acids include methylenebisacrylamide, methylenebismethacrylamide, 1,6-hexamethylenebisacrylamide, 1,6-hexamethylenebismethacrylamide, diethylenetriamine trisacrylamide, xylylenebisacrylamide, and xylylenebismethacrylamide.

Additionally included in component (C) are polyfunctional acrylates and methacrylates, such as urethane acrylates described in JP-A-51-37193, polyester acrylates described in JP-A-48-64183, JP-B-49-43191, and JP-B-52-30490, and epoxy (meth)acrylates obtained by reacting epoxy resin with (meth) acrylic acid. Photo-curing monomers and oligomers presented in the *Journal of the Adhesion Society of Japan*, vol. 20, No. 7, pp.300-308 (1984) are also useful as component (C) .

Commercially available urethane-based oligomers useful as component (C) include NK Oligo series U-4HA, U-4H, U-6HA, U-108A, U-1084A, U-200AX, U-122A, U-340A, U-324A, and UA-100 (available from Shin-Nakamura Chemical Co., Ltd.); UA-306H, AI-600, UA-101T, UA101I, UA-306T, and UA-306I (available from Kyoeisha Chemical Co., Ltd.); and Artresin series UN-9200A, UN-3320HA, UN-3320HB, UN-3320HC, SH-380G, SH-500, and SH-9832 (available from Negami Chemical industrial Co., Ltd.).

Component (C) is preferably used in an amount of 5% to 90% by weight, still preferably 10% to 80% by weight, based on the total weight of the photosensitive layer.

### [IV] Component (D) : Binder polymer

The photosensitive layer can contain (D) a binder polymer in addition to the aforementioned components (A) to (C). Since the binder for use in the photosensitive layer of the photosensitive lithographic printing plate precursor according to the invention not only serves as a film-forming agent but also must be removed with an alkali developing solution, it is selected from organic polymers soluble or swellable in an aqueous alkali solution.

Of a variety of organic polymers, water soluble organic polymers can be used for water development. Such organic polymers include addition polymers having a carboxylic acid group in the side chain, for example, polymers described in JP-A-59-44615, JP-B-54-34327, JP-B-58-12577, JP-B-54-25957, JP-A-54-92723, JP-A-59-53836 and JP-A-59-71048, that is, methacrylic acid copolymers, acrylic acid copolymers, itaconic acid copolymers, crotonic acid copolymers, maleic acid copolymers, and a partially esterified maleic acid copolymers; acid cellulose derivatives having a carboxylic acid group in the side chain; polymers obtained by adding a cyclic acid anhydride to an addition polymer having a hydroxyl group; polyvinylpyrrolidone; and polyethylene oxide. In order to obtain increased strength of a cured film, alcohol-soluble polyamides and a polyether of 2,2-bis (4-hydroxyphenyl)propane and epichlorohydrin are also useful. Particularly preferred of these polymers are copolymers of benzyl (meth)acrylate, (meth) acrylic acid and, if desired, other addition-polymerizable vinyl monomers and copolymers of allyl (meth)acrylate, (meth)acrylic acid and, if desired, other addition-polymerizable vinyl monomers. In addition, polyurethane resins described in JP-B-7-120040, JP-B-7-120041, JP-B-7-120042, JP-B-8-12424, JP-A-63-287944, JP-A-63-287947, JP-A-1-271741, and JP-A-11-352691 are useful as well.

By introducing a radical reactive group into the side chain of these organic polymers, the resulting cured film exhibits increased strength. For example, addition polymerizable functional groups that can be introduced include a group having an ethylenically unsaturatedbond, an amino group, and an epoxy group; functional groups capable of forming a free radical upon irradiation include a mercapto group, a thiol group, a halogen atom, a triazine structure, and an onium salt structure; and polar groups include a carboxyl group and an imide group. Of the addition polymerizable functional groups, an ethylenically unsaturated group such as an acryl group, a methacryl group, an allyl group, and a styryl group are particularly preferred. An amino group, a hydroxyl group, a phosphonic acid group, a phosphoric acid group, a carbamoyl group, an isocyanate group, a ureido group, a ureylene group, a sulfonic acid groups and an ammonio group are also useful functional groups.

The polymers having the addition polymerizable functional group introduced into the side chain thereof can be obtained by, for example, reacting a copolymer comprising a carboxyl-containing monomer unit with an aliphatic epoxy-containing unsaturated compound (e.g., allyl glycidyl ether, glycidyl (meth)acrylate, α-ethylglycidyl (meth)acrylate, glycidyl crotonate, glycidyl isocrotonate, crotonyl glycidyl ether, an alkyl glycidyl itaconate, an alkyl glycidyl fumarate or an alkyl glycidyl maleate) or an alicyclic epoxy-containing unsaturated compound (e.g., 3,4-epoxycyclohexylmethyl (meth)acrylate).

In order to assure developability of the photosensitive layer, it is preferred that the binder polymer have an appropriate molecular weight and acid value. Specifically, the binder polymer preferably has a weight average molecular weight of from 5,000 to 300,000 and an acid value of from 20 to 200.

The proportion of the binder polymer in the photosensitive layer is arbitrarily selected but is preferably 10% to 90% by weight, more preferably 30% to 80% by weight, for securing image strength and the like. It is preferred that a weight ratio of the addition polymerizable ethylenically unsaturated compound as component (C) to the binder polymer as component (D), i . e. , (C) / (D), be 1. 5 or smaller, desirably 0.1 to 1 .5, more desirably 0.1 to 1.0, most desirably 0.1 to 0.8.

It is preferred to add a small amount of a thermal polymerization inhibitor to the photosensitive composition for the photosensitive layer in order to prevent undesirable thermal polymerization of the addition polymerizable ethylenically unsaturated compound during the preparation and storage of the photosensitive composition. Suitable thermal polymerization inhibitors include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxylamine cerium (III) salt, and N-nitrosophenylhydroxylamine aluminum salt. The amount of the thermal polymerization inhibitor to be added is preferably about 0.01% to about 5% by weight based on the total solids content of the photosensitive composition. If needed, a higher fatty acid or a derivative thereof, such as behenic acid or behenic acid amide, can be added to the photosensitive composition in order to prevent polymerization hindrance due to oxygen. Such a compound will be localized on the surface of the photopolymerizable layer during drying following application of the photosensitive composition. The amount of the higher fatty acid or derivative thereof to be added is preferably about 0.5% to about 10% by weight based on the total solids content of the photosensitive composition.

A coloring agent may be added to the photosensitive composition to make the photosensitive layer colored. Suitable coloring agents include pigments, such as phthalocyanine pigments (e.g., C. I. Pigment Blue 15:3, 15:4 and 15:6), azo pigments, carbon black and titanium oxide; and dyes, such as Ethyl Violet, Crystal Violet, azo dyes, anthraquinone dyes, and cyanine dyes. The amount of the coloring agent to be added is preferably about 0.5% to about 5% by weight based on the total solids content of the photosensitive composition.

If desired, additives including inorganic fillers and plasticizers (e.g., dioctyl phthalate, dimethyl phthalate, and tricresyl phosphate) maybe added to improve physical properties of the cured film. The amount of such additives to be added is preferably not more than 10% by weight based on the total solids content of the photosensitive composition.

A surface active agent may be added to the photosensitive composition for the photosensitive layer to improve the surface conditions of the coating film. Suitable surface active agents for that purpose include fluorine-containing nonionic ones.

The above-mentioned components and optional additives are dissolved in an appropriate organic solvent to prepare a photosensitive composition, which is applied to the water-wettable support previously described.

Useful organic solvents includes acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. These solvents can be used individually or as a mixture thereof. The solids content of the photosensitive coating composition is suitably 1% to 50% by weight.

The coating amount of the photosensitive composition is suitably about 0.1 g/m² to about 10 g/m², preferably 0.3 to 5 g/m², still preferably 0.5 to 3 g/m², on solid basis.

An oxygen-barrier protective layer (overcoat) is usually provided on the photosensitive layer to provide protection against oxygen having polymerization inhibitory action. The protective layer preferably has a coating weight of 0.7 to 3.0 g/m². Materials forming the protective layer preferably include water-soluble vinyl polymers, such as polyvinyl alcohol; partial esters, ethers or acetals ofpolyvinyl alcohol; and their copolymers that contain a substantial amount of an unsubstituted vinyl alcohol unit in such a proportion as to exhibit sufficient water solubility. Suitable polyvinyl alcohols have a degree of hydrolysis of 71% to 100% (based on the starting polyvinyl acetate) and a degree of polymerization of 300 to 2400. Examples of commercially available polyvinyl alcohol products that can be used to form the protective layer include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-631, and L-8, all manufactured by Kuraray Co., Ltd. Examples of the above-described copolymers include polyvinyl acetate chloroacetate or propionate, polyvinyl formal and polyvinyl acetal, each having a degree of hydrolysis of 80% to 100%, and their copolymers. Other useful polymers include polyvinyl pyrrolidone, gelatin, and gum arabic. These water-soluble vinyl polymers may be used individually or as a mixture of two or more thereof.

The water-soluble vinyl polymer is applied as a solution preferably in pure water. A polymer solution in a mixed solvent of pure water and an alcohol, e.g., methanol or ethanol, or a ketone, e.g., acetone or methyl ethyl ketone, will do. A suitable concentration of the solid content in the coating solution is 1% to 20% by weight. The oxygen-barrier protective layer may further contain known additives, such as a surface active agent for improving the coating properties and a water-soluble plasticizer for improving the physical properties of the film. Examples of the water-soluble plasticizer include propionamide, cyclohexanediol, glycerol, and sorbitol. A water-soluble (meth) acrylic polymer may also be added to the polymer solution. The coating weight preferably ranges about 0.1 g/m² to about 15 g/m², still prferably 1.0 g/m² to about 5.0 g/m², on solid basis.

### [V] Plate-making process

The lithographic printing plate precursor of the invention is imagewise exposed and developed with a developer to make a lithographic printing plate. As a light source for exposure, an AlGaInN semiconductor laser is recommended for its wavelength characteristics and from the economical consideration. Commercially available InGaN semiconductor lasers have output powers of 5 to 30 mW.

Any exposure mechanism is applicable, such as an inner drum exposure method, an outer drum exposure method, and a flatbed method. The photosensitive layer can be designed to be developable even with neutral water or weakly alkaline water by making up the photosensitive layer of highly water soluble materials. A lithographic printing plate precursor having a so designed photosensitive layer can be applied to a so-called on-press development system, in which a printing plate precursor is mounted on a press followed by imagewise exposure and development to make a printing plate. If necessary, the entire area of the imagewise exposed printing plate precursor is heated before development to accelerate image forming reaction in the photosensitive layer, thereby to improve the sensitivity and press life and to stabilize the sensitivity. After development (hereinafter described), the entire area of the resulting printing plate may be heated or exposed to light to improve image strength or press life. The heating before development is preferably carried under mild conditions of 150°C or lower temperatures. On the other hand, the heating after development is performed at much higher temperatures, usually from 200° to 500°C.

The developer that can be used to develop the exposed printing plate precursor preferably includes, but is not limited to, aqueous solutions containing an inorganic alkali salt and a nonionic surface active agent and having a pH of 11.0 to 12.5.

The inorganic alkali salt includes sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These alkali agents can be used either individually or as a mixture of two or more thereof.

In using a silicate as an alkali agent, the developing performance of the developer is easily adjusted by selecting the alkali concentration and the mixing ratio of silicon oxide (SiO₂) and an alkali oxide (M₂O: where M represents an alkali metal or an ammonium group), which are components of the alkali silicate. In the developer containing a silicate, the SiO₂/M₂O molar ratio is preferably 0.5 to 3.0, still preferably 1.0 to 2.0. The concentration of the SiO₂/M₂O in the aqueous alkali solution is preferably 1% to 10% by weight, still preferably 3% to 8% by weight, particularly preferably 4% to 7% by weight. With that concentration being 1% by weight or higher, satisfactory developing performance and treatment capacity will be retained. With that concentration being 10% by weight or lower, the developer hardly generates precipitates or crystals and hardly gels on being neutralized after use, which favors to disposal of waste liquid.

For the purpose of delicately adjusting the alkali concentration or of helping the photosensitive layer be dissolved in the developer, an organic alkali maybe auxiliarily added to the developer. Such an organic alkali includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These organic alkalis can be used either individually or as a mixture of two or more thereof.

The developer may further contain a surface active agent. Examples of suitable surface active agents include nonionic surface active agents having a polyoxyalkylene ether group, other nonionic surface active agents, such as polyoxyethylene alkyl esters (e.g., polyoxyethylene stearate), sorbitan alkyl esters (e.g., sorbitan monolaurate, sorbitan monostearate, sorbitan distearate, sorbitan monooleate, sorbitan sesquioleate, and sorbitan trioleate), and fatty acid monoglycerides (e.g., glycerol monostearate and glycerol monooleate); anionic surface active agents, such as alkylbenzenesulfonates (e.g. sodium dodecylbenzenesulfonate), alkylnaphthalenesulfonates (e.g., sodium butylnaphthalenesulfonate, sodium pentylnaphthalenesulfonate, sodium hexylnaphthalenesulfonate, and sodium octylnaphthalenesulfonate), alkylsulfates (e.g., sodium laurylsulfate), alkylsulfonates (e.g., sodium dodecylsulfonate) and sulfosuccinic acid ester salts (e.g., sodium dilaurylsulfosuccinate) ; and amphoteric surface active agents, such as alkyl betaines (e.g., lauryl betaine and stearyl betaine) and amino acids. The nonionic surface active agents having a polyoxyalkylene ether group, particularly those represented by formula (VI) shown below are preferred.

R₄₀-O- (R₄₁-O)ₚH (VI)

wherein R₄₀ represents a substituted or unsubstituted alkyl group having 3 to 15 carbon atoms, a substituted or unsubstituted aromatic hydrocarbon group having 6 to 15 carbon atoms or a substituted or unsubstituted heterocyclic aromatic group having 4 to 15 carbon atoms; R₄₁ represents a substituted or unsubstituted alkylene group having 1 to 100 carbon atoms; and p represents an integer of from 1 to 100.

Examples of the substituent of the subs ti tuted alkyl group, aromatic hydrocarbon group, and heterocyclic aromatic group as R₄₀ include an alkyl group having 1 to 20 carbon atoms, a halogen atom (e.g. , Br, Cl or I), an aromatic hydrocarbon group having 6 to 15 carbon atoms, an aralkyl group having 7 to 17 carbon atoms, an alkoxy group having 1 to 20 carbon atoms, an alkoxycarbonyl group having 2 to 20 carbon atoms, and an acyl group having 2 to 15 carbon atoms. Examples of the substituent of the substituted alkylene group as R₄₁ include an alkyl group having 1 to 20 carbon atoms and an aromatic hydrocarbon group having 6 to 15 carbon atoms. In the definition of formula (VI), the aromatic hydrocarbon group includes phenyl, tolyl, naphthyl, anthryl, biphenyl, and phenanthryl. The heterocyclic aromatic group as R₄₀ includes furyl, thionyl, oxazolyl, imidazolyl, pyranyl, pyridinyl, acridinyl, benzofuranyl, benzothionyl, benzopyranyl, benzoxazolyl, and benzimidazolyl.

When p in formula (VI) is 2 or greater, the moiety (R₄₁-O)ₚ maybe composed of two or more different alkyleneoxy units within the aforementioned definition. For example, an ethyleneoxy unit and one or more of a propyleneoxy unit, an isopropyleneoxy unit, a butyleneoxy unit, and an isobutyleneoxy unit may be combined at random or in blocks.

The surface active agents having a polyoxyalkylene ether group can be used either individually or as a combination thereof. The concentration of the surface active agents having a polyoxyalkylene ether group in the developer effective for improving developing performance and press life of the resulting printing plate is preferably 1% to 30% by weight, more preferably 2% to 20% by weight.

Specific examples of the nonionic surface active agents represented by formula (VI) include polyoxyethylene alkyl ethers, such as polyoxyethylene lauryl ether, polyoxyethylene cetyl ether, and polyoxyethylene stearyl ether; polyoxyethylene aryl ethers, such as polyoxyethylene phenyl ether and polyoxyethylene naphthyl ether; and polyoxyethylene alkylaryl ethers, such as polyoxyethylene methylphenyl ether, polyoxyethylene octylphenyl ether, and polyoxyethylene nonylphenyl ether.

The above-described surface active agents may be used either individually on in their combination in a concentration of preferably 1% to 30% by weight, more preferably 2% to 20% by weight in the developer.

The pH of the developer is not particularly limited but preferably ranges 11.0 to 12.7, still preferably 11.5 to 12.5. The electric conductivity of the developer is preferably 3 to 30 mS/cm. With conductivity of at least 3 mS/cm, the developer reliably dissolves the photopolymerizable layer on an aluminum support and leaves no cause of stains on printing. As long as the conductivity is not more than 30 mS/cm, the salt concentration is prevented from increasing too high so as not to extremely retard dissolution of the photopolymerizable layer, and thus film residue in non-exposed areas can be avoided. A still preferred conductivity is in the range of from 5 to 20 mS/cm.

Development of the exposed lithographic printing plate precursor of the invention is carried out in a usual manner. For example, the exposed precursor is immersed in a developer at about 0° to 60°C, preferably about 15° to 90°C, and rubbed with a developing brush. Where an automatic developing machine is used, since the developer in a developing tank is fatigued or exhausted with the throughput, it may be occasionally replaced with fresh one, or the developing tank is replenished with a replenisher to restore the processing capacity.

The thus developed printing plate precursor is subjected to appropriately combined post treatments using an appropriate combination of washing water, a rinsing solution containing a surface active agent, etc., and a desensitizing solution containing gum arabic, a starch derivative, etc. to complete plate-making as taught in JP-A-54-8002, JP-A-55-115045, and JP-A-59-58431. To bring about improved impression capacity, the lithographic printing plate thus post-treated may further be subjected to the post exposure treatment proposed in JP-A-2000-89478 or a heat treatment such as burning. The resulting lithographic printing plate is used to carry out large volume printing on an offset printing machine.

### EXAMPLES

The present invention will now be illustrated in greater detail with reference to Examples, but it should be understood that the invention is not deemed to be limited thereto. Unless otherwise noted, all the percents and parts are by weight.

### EXAMPLE 1

### 1) Preparation of support

A 0.3 mm thick aluminum plate (material grade: 1S) was grained with a nylon brush (#8) and an aqueous slurry of pumice stone (800 mesh). After thoroughly washing with water, the aluminum plate was etched by immersion in a 10% sodium hydroxide aqueous solution at 70°C for 60 seconds, followed by washing, with running water. After neutralizing by immersion in 20% nitric acid, followed by washing with water, the aluminum plate was electrolytically grained in a 1% nitric acid aqueous solution by applying a sine wave alternating current under a condition of VA=12.7 V with an electric quantity of 300 Coulomb/dm² at the anode. The thus grained surface had a mean roughness Ra of 0.45 µm. The plate was desmutted by immersing in a 30% sulfuric acid aqueous solution at 55°C for 2 minutes. The plate was then anodized in a 20% sulfuric acid aqueous solution at 33°C at a current density of 5 A/dm² for 50 seconds, with a cathode placed on the grained surface side, to form an anodized film to a thickness corresponding to 2.6 g/m².

### 2) Application of primer coat

A primer solution prepared from 0.3 g of polymer (P1) shown below, 60.0 g of pure water, and 939.7 g of methanol was applied to the resulting aluminum support with a bar coater to a dry thickness of 2 mg/m² and dried at 80°C for 20 seconds to form a primer coat.

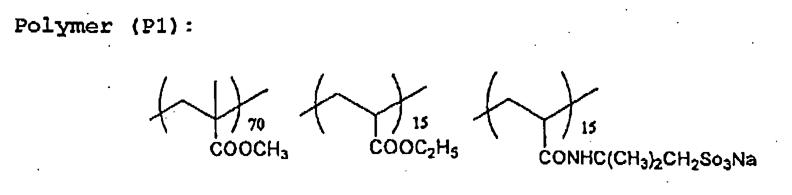

### 3) Formation of photosensitive layer

A photosensitive composition (P-1) having the following formulation was applied to the primer-coated aluminum support with a bar coater to a dry thickness of 1.1 g/m² and dried at 100°C for 1 minute.

| Formulation of photosensitive composition P-1: | |
|---|---|
| Ethylenically unsaturated compound (A1) | 1.0 part |
| Binder polymer (B1) | 2.0 parts |
| Sensitizing dye (D29) | 0.15 parts |
| Polymerization initiator (C1) | 0.12 parts |
| ε-Phthalocyanine (F1) dispersion | 0.02 parts |
| Sensitization assistant (G1) | 0.5 parts |
| Fluorine-containing nonionic surfactant (Megafac F-780F, available from Dainippon Ink & Chemicals, Inc.) | 0.02 parts |
| Methyl ethyl ketone | 26.0 parts |
| Propylene glycol monomethyl ether | 26.3 parts |

The structural formulae of the ethylenically unsaturated compound (A1), binder polymer (B1), polymerization initiator (C1), ε-phthalocyanine (F1), and sensitization assistant (G1) are shown below. Sensitizing dye (D29) is one of the previously listed sensitizing dyes.

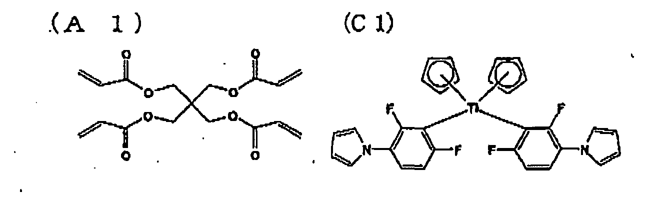

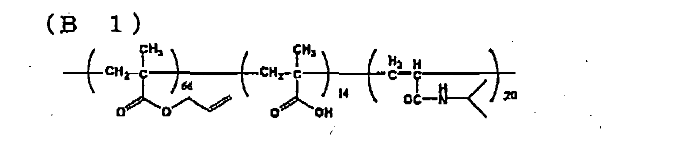

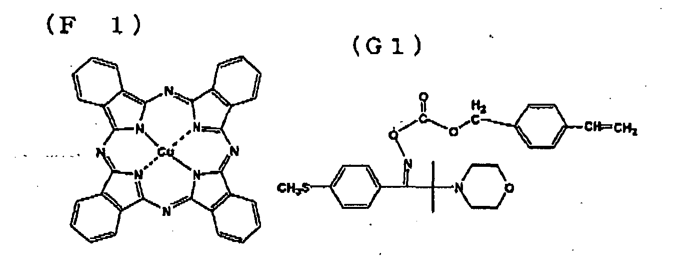

### 4) Formation of protective layer

An aqueous solution shown below was applied to the photosensitive layer with a bar coater to a dry thickness of 2.5 g/m² and dried at 120°C for 1 minute to form a protective layer. A photosensitive lithographic printing plate precursor was thus completed.

| Formulation of solution for protective layer: | |
|---|---|
| Polyvinyl alcohol (degree of saponification: 98 mol%; degree of polymerization: 500) | 5.0 parts |
| Nonionic surfactant EMALEX 710 (available from Nippon Nyukazai Co., Ltd.) | 0.09 parts |
| Pure water | 94.91 parts |

### 5) Plate-making (1)

The photosensitive lithographic printing plate precursor was mounted on a violet platesetter Vx 9600 CTP (produced by FUJIFILM Electronic Imaging Ltd.; InGaN semiconductor laser emission: 405 nm±10 nm; output power: 30 mW) and scanned at an exposure of 90 µJ/cm² and a resolution of 2438 dpi to draw two-pixel lines. The exposed plate was automatically sent to an automatic development machine LP1250PLX (equipped with a brush) directly connected to the platesetter, where it was heated at 100°C for 10 seconds, washed with water to remove the polyvinyl alcohol protective layer, and developed with a 5-fold water-diluted developer DV-2 (available from Fuji Photo Film Co., Ltd.) at 28°C for 20 seconds. After the development, the plate was washed in a rinsing bath, sent to a gumming bath, a double water-diluted gum solution FP-2W (available from Fuji Photo Film). The gummedplate was dried in hot air and discharged from the developing machine as lithographic printing plate P-1A (with two-pixel lines, developed with a brush).

### 6) Plate-making (2)

The photosensitive lithographic printing plate precursor was exposed and processed in the same manner as in (5) above, except that the brush was removed from the developing tank of LP1250PLX. The resulting printing plate was designated P-1B.

### 7) Measurement of line width

The two-pixel lines on each of P-1A and P-1B were photographed using a microscope VH-8000 equipped with a zoom lens VH-Z450 (from Keyence Corp.) at a magnification of 2000 times. The line widths Wa and Wb were measured to obtain the difference (Wb - Wa). The results are shown in Table 1 below.

### 8) Evaluation of tint uniformity

The photosensitive lithographic printing plate precursor was fixed on a violet platesetter Vx 9600 CTP (produced by FUJIFILM Electronic Imaging Ltd.; InGaN semiconductor laser emission: 405 nm±10 nm; output power: 30 mW) and scanned at an exposure of 90 µJ/cm² and a resolution of 2438 dpi to form a 35% tint image of 21 µm dot size by FM screening. The exposed plate was automatically sent to an automatic development machine LP1250PLX (equipped with a brush) directly connected to the platesetter, where it was heated at 100°C for 10 seconds, washed with water to remove the polyvinyl alcohol protective layer, and developed with a 5-fold water-diluted developer DV-2 (available from Fuji Photo Film Co., Ltd.) at 28°C for 20 seconds. After the development, the plate was washed in a rinsing bath, sent to a gumming bath, a double water-diluted gum solution FP-2W (available from Fuji Photo Film) . The gummed plate was dried in hot air and discharged from the developing machine to make a lithographic printing plate with a tint image. The area ratio of the tint image on the printing plate was measured with a digital dot meter CC-dot to obtain an area difference between the maximum and the minimum (δdot). The results obtained are shown in Table 1.

### EXAMPLES 2 AND 3

Photosensitive lithographic printing plate precursors were produced in the same manner as in Example 1, except for replacing the photosensitive composition P-1 with photosensitive composition P-2 or P-3 having the same formulation as composition P-1 except for changing the sensitizing dye as shown in Table 1. Each of the printing plate precursors was exposed and processed in the same manner as in Example 1, and the resulting plating plate was evaluated in the same manner. The results obtained are shown in Table 1.

### COMPARATIVE EXAMPLE 1

A photosensitive lithographic printing plate precursor was produced in the same manner as in Example 1, except for replacing the photosensitive composition P-1 with photosensitive composition P-4. The photosensitive composition P-4 has the same formulation as composition P-1 except that the amounts of the ethylenically unsaturated compound (A1) and the binder polymer (B1) were changed to 2.0 parts and 1.0 part, respectively. The printing plate precursor was exposed and processed in the same manner as in Example 1, and the resul ting plating plate was evaluated in the same manner . The results obtained are shown in Table 1.

### EXAMPLE 4

A photosensitive lithographic printing plate precursor was produced in the same manner as in Example 1, except that photosensitive composition P-5 having the following formulation was applied in place of composition P-1 to a dry thickness of 1.8 g/m². The printingplateprecursor was exposed and processed in the samemanner as in Example 1, and the resulting plating plate was evaluated in the same manner. The results obtained are shown in Table 1.

| Formulation of photosensitive composition P-5: | |
|---|---|
| Ethylenically unsaturated compound (X1) | 0.5 parts |
| Binder polymer (X2) | 1.0 part |
| Sensitizing dye (D29) | 0.1 parts |
| Polymerization initiator (X3) | 0.1 parts |
| ε-Phthalocyanine (F1) dispersion | 0.02 parts |
| Sensitization assistant (X4) | 0.0005 parts |
| Fluorine-containing nonionic surfactant (Megafac F-780F, available from Dainippon Ink & Chemicals, Inc.) | 0.02 parts |
| Methyl ethyl ketone | 26.0 parts |
| Propylene glycol monomethyl ether | 26.3 parts |

The structural formulae of the ethylenically unsaturated compound (X1), binder polymer (X2), polymerisation initiator (X3), and sensitization assistant (X4) used in photosensitive composition P-5 are shown below.

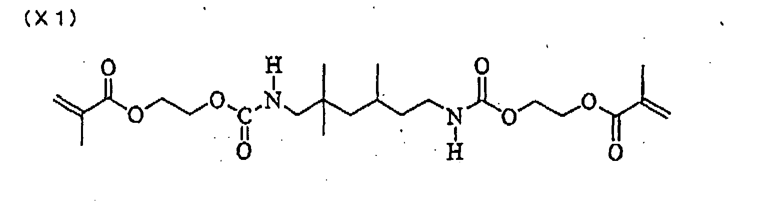

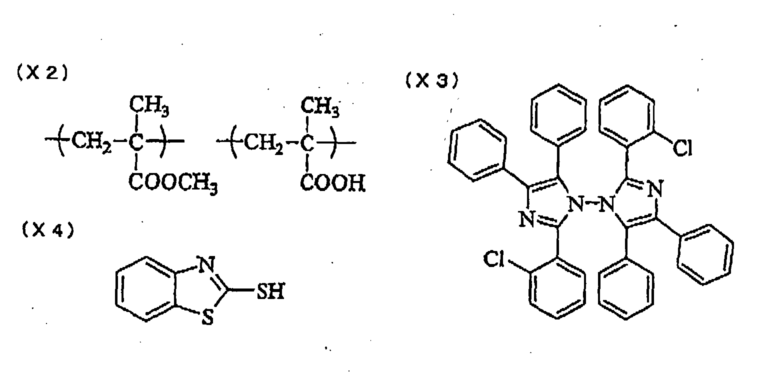

### COMPARATIVE EXAMPLE 2

A photosensitive lithographic printing plate precursor was produced in the same manner as in Example 4, except for replacing photosensitive composition P-5 with photosensitive composition P-6. The photosensitive composition P-6 had the same formulation as composition P-5, except for changing the amounts of the ethylenically unsaturated compound (X1) and the binder polymer (X2) to 1.0 part and 0.5 parts, respectively. The printing plate precursor was exposed and processed in the same manner as in Example 1, and the resulting plating plate was evaluated in the same manner. The results obtained are shown in Table 1.

**TABLE 1**

| | Sensitizing Dye | Photosensitive Layer | Wb-Wa (µm) | δdot (%) |
|---|---|---|---|---|
| Example 1 | D29 | P-1 | 4.1 | 4.0 |
| Example 2 | D30 | P-2 | 3.9 | 3.0 |
| Example 3 | D31 | P-3 | 4.0 | 4.5 |
| Example 4 | D29 | P-5 | 4.5 | 5.0 |
| Compara. Example 1 | D29 | P-4 | 11.0 | 12.5 |
| Compara. Example 2 | D29 | P-6 | 13.0 | 15.0 |

As is apparent from Table 1, photosensitive lithographic printing plate precursors whose developability is such that the reproduced line width difference between Wa (developed with a brush) and Wb (developed without a brush) is not greater than 5 µm provide lithographic printing plates having satisfactory uniformity in tint in FM screening.

This application is based on Japanese Patent application JP 2004-036442, filed February 13, 2004, the entire content of which is hereby incorporated by reference, the same as if set forth at length.

## Claims

1. A photosensitive lithographic printing plate precursor comprising a support and at least one photopolymerizable layer for imaging by scanning with a laser beam, and showing a difference of 5 µm or smaller between Wa (µm) and Wb (µm) when imagewise exposed with a laser beam and developed in a developing tank containing an aqueous alkali developer in an automatic developing machine, wherein Wa is a width of a line formed along a, fast scanning direction and developed using a developing brush set in the developing tank in contact with a surface of the exposed lithographic printing plate precursor, and Wb is a width of a line formed along a fast scanning direction and developed without the developing brush.

2. The photosensitive lithographic printing plate precursor according to claim 1, wherein the photopolymerizable layer comprises:
(A) a sensitizing dye having an absorption maximum in a wavelength region of from 360 nm to 450 nm,
(B) a polymerization initiator, and
(C) an addition polymerizable compound having an ethylenically unsaturated double bond.

3. The photosensitive lithographic printing plate precursor according to claim 2, wherein the photopolymerizable layer further comprises (D) a binder polymer, a weight ratio of the component (C) to the component (D) being 1.5 or less.

4. The photosensitive lithographic printing plate precursor according to claim 3, wherein the weight ratio of the component (C) to the component (D) being 0.1 to 1.5.

5. The photosensitive lithographic printing plate precursor according to claim 3, wherein the weight ratio of the component (C) to the component (D) being 0.1 to 1.0.

6. The photosensitive lithographic printing plate precursor according to claim 3, wherein the weight ratio of the component (C) to the component (D) being 0.1 to 0.8.

7. The photosensitive lithographic printing plate precursor according to claim 1, wherein the difference is 4.5 µm or smaller.

8. The photosensitive lithographic printing plate precursor according to claim 2, wherein the polymerization initiator (B) is hexaarylbiimidazole or a titanocene compound.

9. The photosensitive lithographic printing plate precursor according to claim 3, wherein the component (D) is an organic polymer having a radical reactive group in a side chain of the organic polymer.

10. The photosensitive lithographic printing plate precursor according to claim 1, further comprising a protective layer containing a water-soluble vinyl polymer so that the Support, the at least one photopolymerizable layer and the protective layer are in this order.
